(19) **Europäisches Patentamt / European Patent Office / Office européen des brevets**

(11) **EP 3 695 435 B1**

(12) **EUROPEAN PATENT SPECIFICATION**

(45) Date of publication and mention of the grant of the patent:
**20.07.2022 Bulletin 2022/29**

(21) Application number: **18796274.1**

(22) Date of filing: **11.10.2018**

(51) International Patent Classification (IPC):
**H01J 37/32** *(2006.01)*     **H03H 7/40** *(2006.01)*

(52) Cooperative Patent Classification (CPC):
**H01J 37/32183; H01J 37/321; H01J 37/32146; H01J 37/32174;** H03H 7/40

(86) International application number:
**PCT/US2018/055487**

(87) International publication number:
**WO 2019/075256 (18.04.2019 Gazette 2019/16)**

(54) **MATCHED SOURCE IMPEDANCE DRIVING SYSTEM AND METHOD OF OPERATING THE SAME**

ANGEPASSTES QUELLENIMPEDANZANSTEUERUNGSSYSTEM UND BETRIEBSVERFAHREN DAFÜR

SYSTÈME D'ENTRAÎNEMENT D'IMPÉDANCE DE SOURCE ADAPTÉE ET SON PROCÉDÉ DE FONCTIONNEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.10.2017 US 201715730131**

(43) Date of publication of application:
**19.08.2020 Bulletin 2020/34**

(73) Proprietor: **Advanced Energy Industries, Inc.**
**Fort Collins, CO 80525 (US)**

(72) Inventor: **VAN ZYL, Gideon Johannes Jacobus**
**Fort Collins**
**Colorado 80525 (US)**

(74) Representative: **Ford, Esther Mary**
**Marks & Clerk LLP**
**62-68 Hills Road**
**Cambridge CB2 1LA (GB)**

(56) References cited:
**WO-A1-2017/011264**     **WO-A2-2010/129398**
**US-A1- 2009 281 741**     **US-A1- 2015 270 104**

**Description**

## TECHNICAL FIELD

Aspects of the present disclosure relate to improved methods and systems for driving plasma processing systems.

## BACKGROUND AND INTRODUCTION

Plasma processing systems are used to deposit thin films on a substrate using processes such as chemical vapor deposition (CVD) and physical vapor deposition (PVD) as well as to remove films from the substrate using etch processes. The plasma is often created by coupling radio frequency (RF) or direct current (DC) generators to a plasma chamber filled with gases injected into the plasma chamber at low pressure. Typically RF power is applied to the plasma chamber using an RF generator coupled to an impedance matching network. The matching network is, in turn, coupled to an antenna that couples to the plasma. Common antennas used in this application are capacitively coupled electrodes and inductively coupled coils.

Maintaining uniform deposition or etch rates over the surface of the substrate is essential. Control over the electromagnetic field distribution in the chamber is a factor in achieving uniform deposition and etch rates. Electromagnetic field distribution can be improved by using antennas with multiple inputs or multiple antennas and driving the antenna inputs with controlled amplitude and relative phases. Splitting the output from a single RF generator to drive multiple antenna inputs with the required amplitude and phase relationships is difficult to implement. Using separate RF generators coupled to the antenna inputs requires a new type of RF generator because of the possibility of strong coupling between inputs leading to undesirable interaction between generators, among other challenges. WO 2017/011264 A1 discloses radio frequency power delivery systems and centralized control of RF impedance matching networks. WO 2010/129398 A2 relates to a power distribution system for the uniform delivery of single frequency RF power into multiple points across a large-area electrode. US 2009/281741 A1 discloses a system and method for monitoring a process system. The processing system is utilizing average reflection coefficient calculations of measured parameters related to the power applied by the generator. US 2015/270104 A1 relates to a system and method for controlling the source impedance of a power generator using calculations based on the real and imaginary part of the load reflection coefficient. US 2010/175832 A1 relates to a plasma processing apparatus and a plasma generating apparatus using inductively coupled electron cyclotron resonance plasma distributing power to multiple antenna.

It is with these observations in mind, among others, that aspects of the present disclosure were conceived.

## SUMMARY

According to one embodiment, a radio frequency (RF) generator having an effective source impedance $Z_g$ at a reference point (e.g. at the generator output) includes a reference input and controls the magnitude and phase relative to the phase of a signal received at the reference input of $K(v + Z_g i)$ at the reference point where $v$ and $i$ are the voltage at the reference point and current out of the generator at the reference point, respectively, and $K$ is a scalar. In yet another embodiment the generator maintains control of $K(v + Z_g i)$ when delivering and when absorbing power.

## BRIEF DESCRIPTION OF THE DRAWINGS

The various features and advantages of the technology of the present disclosure will be apparent from the following description of particular embodiments of those technologies, as illustrated in the accompanying drawings. It should be noted that the drawings are not necessarily to scale; however the emphasis instead is being placed on illustrating the principles of the technological concepts. Also, in the drawings the like reference characters may refer to the same parts throughout the different views. The drawings depict only typical embodiments of the present disclosure and, therefore, are not to be considered limiting in scope.

FIG. 1 illustrates an example matched source impedance driving system that may be implemented on a plasma chamber according to one embodiment of the present disclosure.

FIG. 2 illustrates a Thevenin equivalent circuit of an RF generator connected to a load.

FIG. 3A illustrates an example RF generator that may be used with the system of FIG. 1 according to one embodiment of the present disclosure.

FIG. 3B illustrates an example filter that may be used with the RF generator of FIG. 3A according to one embodiment of the present disclosure.

FIG. 4 illustrates an example process that may be performed to prepare to drive a plasma system according to one embodiment of the present disclosure.

FIG. 5 illustrates an example process that may be performed to drive a plasma system according to one embodiment of the present disclosure.

FIG. 6 illustrates an example computer system according to one embodiment of the present disclosure.

## DETAILED DESCRIPTION

Embodiments of the present disclosure provide a matched source impedance driving system for a multi-input plasma chamber that uses multiple phase locked sources (RF generators) with each source controlled to deliver forward power calculated with respect to the source's source impedance to drive multiple inputs of a plasma chamber. Whereas conventional techniques have been implemented with a single RF generator and a fixed or variable distribution network to drive multiple antenna inputs to a plasma chamber, in practice it has been difficult to maintain adequate amplitude and phase relationships between the inputs while simultaneously providing well-matched impedances to the outputs of the generator. Embodiments of the present disclosure provide a solution to this problem, among other problems, by providing an RF generator that controls a magnitude and a phase with respect to an input signal provided at a reference input of a linear combination of voltage and current at some reference point (typically the output of the generator) when delivering and when absorbing power. If this linear combination of voltage and current is chosen as a scalar times the sum of the voltage and the current multiplied by the source impedance of the generator, the controlled quantity (effectively a scalar times the forward or incident component as encountered in the theory of scattering parameters) is insensitive to the impedance presented to the generator. Additionally, utilizing parallel smaller current sources at RF frequencies can make such an approach attractive for infinite reference impedance scenarios.

In order to achieve uniform plasma excitation in a plasma chamber, multiple inputs to the exciting antenna may be utilized, which may be driven coherently with a certain amplitude and phase relationship among the multiple inputs. Once an excitation that creates the desired electromagnetic field in the plasma chamber is determined (theoretically or through experimentation), the excitation can be specified in numerous ways. If, for example, the voltages at all $N$ inputs are recorded, specifying the voltages at the $N$ inputs is one specification of the desired excitation. Alternatively, the required voltages may be applied to the system and the $N$ input currents measured. Specifying the $N$ input currents is an equivalent specification that produces the same electromagnetic field in the chamber (assuming that the system is well behaved and does not admit multiple solutions as some nonlinear systems may do). In general, at each input a linear combination of the voltage and current may be specified that is equivalent to the desired excitation. The choice of how the excitation is specified (e.g., voltage, current, or combinations thereof, such as forward component) to drive the multiple inputs is often not under the control of the provider of the sources used to drive the inputs since it is often determined by the user of the plasma processing equipment. For a given specified excitation, the correct choice of source impedance for the generating equipment is often important. For example, if the amplitude and phase relationship is specified as forward voltage (i.e. voltage plus current multiplied by a reference impedance), driving the inputs with a generator having a source impedance equal to the reference impedance dramatically simplifies the control problem because in that case the controlled variable is insensitive to the impedance presented to the generator by the plasma system.

An important control parameter is the total power delivered to the plasma system. Using a single generator and distribution network to distribute power to the antenna inputs allows for simple control of the total power delivered to the plasma system. Controlling a linear combination of voltage and current, however, does not control delivered power directly. (The same value for a chosen linear combination of voltage and current will result in different values of delivered power depending on the impedance presented to the generator.) The nonlinear nature of the plasma load as well as delays between individual generators reaching their target values and variations in the plasma load can result in excessive power being delivered to the plasma while the individual generators are approaching their targeted linear combinations of voltage and current. It is contemplated that in addition to controlling the linear combination of voltage and current, each individual generator will have limits on parameters such as delivered power and a combination of forward and reflected power calculated with respect to some reference impedance. It is also contemplated that, the individual generators will report measurements selected from voltage, current, impedance, delivered power, forward power, and reflected power or derivatives of these measurements (e.g. load reflection coefficient, reactive power etc.) to a master controller that will adjust the targeted linear combination of voltage and current for each generator to ensure compliance with a total delivered power goal and other criteria such as maximum power delivered by an individual generator, maximum voltage at an input or inputs etc. If such power control is performed, the linear combinations of voltage and current at the antenna inputs may in some cases, be controlled only up to a scale factor. For example, if the setpoints to the individual generators are (s1, s2, ... sN), the setpoints can be adjusted to k(s1,s2, ... sN) with k being a real number in order to maintain the inputs up to a scale factor while satisfying a total delivered power requirement.

Specific linear combinations of voltage and current may be more closely related to the desired electromagnetic field in the chamber than others (e.g. if an antenna is magnetically coupled to the plasma, current may be more closely related to the electromagnetic field than voltage; if the antenna is capacitively coupled to the plasma, voltage may be more closely related to the electromagnetic field than current). Situations may arise where the linear combination of voltage and current that makes a generator insensitive to variations in the plasma system makes the electromagnetic field distribution sensitive to small changes in the plasma system. In such a case, close control over the electromagnetic field variation may be obtained by adjusting the setpoints given to the generators in order to maintain those linear combinations of voltage and current that are closely related to the electromagnetic field in the plasma chamber. The required adjustments may be determined by perturbing the generator setpoints to determine the linearized response of the system around the operating point and then calculating the adjustments to the generator setpoints. To enable such calculations two linearly independent combinations of voltage and current should be obtained from each generator. e.g. voltage and current; or forward and reflected power calculated with respect to an impedance with a non-zero resistive part; or voltage plus current and voltage minus current etc.)

To illustrate the process, let the linear combination of voltage and current that matches the generator source impedance of the $k$-th generator connected to the $k$-th antenna input be $f_k$, and the second linear independent combination of voltage and current obtained from the generator be $r_k$. Define $A_k$ as the matrix relating $f_k$ and $r_k$ to the voltage and current at the $k$-th antenna input, $v_k$ and $i_k$, respectively:

$$\begin{bmatrix} f_k \\ r_k \end{bmatrix} = \begin{bmatrix} a_{k11} & a_{k12} \\ a_{k21} & a_{k22} \end{bmatrix} \begin{bmatrix} v_k \\ i_k \end{bmatrix} \stackrel{\text{def}}{=\joinrel=} A_k \begin{bmatrix} v_k \\ i_k \end{bmatrix}, \quad k \in \{1, 2, \ldots, N\}$$

Let the linear combination of voltage and current at the $k$-th antenna input that makes the electromagnetic field distribution insensitive to small changes in the plasma system be $c_k$. Define $C_k$ as the matrix relating $c_k$ to $v_k$ and $i_k$:

$$c_k = \begin{bmatrix} c_{k1} & c_{k2} \end{bmatrix} \begin{bmatrix} v_k \\ i_k \end{bmatrix} \stackrel{\text{def}}{=\joinrel=} C_k \begin{bmatrix} v_k \\ i_k \end{bmatrix}, \quad k \in \{1, 2, \ldots, N\}$$

Let the linearized response of the system around the operating point be $H$. With $\Delta$ signifying a (generally small) change:

$$\begin{bmatrix} \Delta r_1 \\ \Delta r_2 \\ \vdots \\ \Delta r_N \end{bmatrix} = \begin{bmatrix} h_{11} & h_{12} & \ldots & h_{1N} \\ h_{21} & h_{22} & \ldots & h_{2N} \\ \ldots \\ h_{N1} & h_{N2} & \ldots & h_{NN} \end{bmatrix} \begin{bmatrix} \Delta f_1 \\ \Delta f_2 \\ \vdots \\ \Delta f_N \end{bmatrix} \stackrel{\text{def}}{=\joinrel=} H \begin{bmatrix} \Delta f_1 \\ \Delta f_2 \\ \vdots \\ \Delta f_N \end{bmatrix}$$

$$\stackrel{\text{def}}{=\joinrel=} \begin{bmatrix} H_1 \\ H_2 \\ \ldots \\ H_N \end{bmatrix} \begin{bmatrix} \Delta f_1 \\ \Delta f_2 \\ \vdots \\ \Delta f_N \end{bmatrix}$$

The linearized response matrix, $H$, can be determined column by column by perturbing one generator at a time, as follows:

$$
\begin{bmatrix} h_{1k} \\ h_{2k} \\ \ldots \\ h_{Nk} \end{bmatrix} = \begin{bmatrix} \Delta r_1/\Delta f_k \\ \Delta r_2/\Delta f_k \\ \vdots \\ \Delta r_N/\Delta f_k \end{bmatrix}, \ k \in \{1, 2, \ldots, N\}
$$

Assuming that the values of $c_k$ that result in the desired electromagnetic field distribution are known, and since the current values of $c_k$ can be calculated from $f_k$ and $r_k$, the desired change in $c_k$ to achieve the desired values, $\Delta c_k$, is known for $k = 1, 2, ...N$. With $I_k$ the $k$-th row of the $N$ by $N$ identity matrix:

$$
\Delta c_k = C_k \begin{bmatrix} \Delta v_k \\ \Delta i_k \end{bmatrix} = C_k A_k^{-1} \begin{bmatrix} \Delta f_k \\ \Delta r_k \end{bmatrix}
$$

$$
= C_k A_k^{-1} \begin{bmatrix} I_k \\ H_k \end{bmatrix} \begin{bmatrix} \Delta f_1 \\ \Delta f_2 \\ \vdots \\ \Delta f_N \end{bmatrix}, \ k \in \{1, 2, \ldots, N\}
$$

$$
\begin{bmatrix} \Delta c_1 \\ \Delta c_2 \\ \vdots \\ \Delta c_N \end{bmatrix} = \begin{bmatrix} C_1 A_1^{-1} \begin{bmatrix} I_1 \\ H_1 \end{bmatrix} \\ C_2 A_2^{-1} \begin{bmatrix} I_2 \\ H_2 \end{bmatrix} \\ \vdots \\ C_N A_N^{-1} \begin{bmatrix} I_N \\ H_N \end{bmatrix} \end{bmatrix} \begin{bmatrix} \Delta f_1 \\ \Delta f_2 \\ \vdots \\ \Delta f_N \end{bmatrix}
$$

$$
\overset{\text{def}}{=} M \begin{bmatrix} \Delta f_1 \\ \Delta f_2 \\ \vdots \\ \Delta f_N \end{bmatrix}
$$

$$
\begin{bmatrix} \Delta f_1 \\ \Delta f_2 \\ \vdots \\ \Delta f_N \end{bmatrix} = M^{-1} \begin{bmatrix} \Delta c_1 \\ \Delta c_2 \\ \vdots \\ \Delta c_N \end{bmatrix}
$$

Note that $H$ does not have to be known exactly for a repeated process of adjusting the $f_k$ to achieve the desired $c_k$ to converge to the desired values. The step of perturbing the generators to determine $H$ can either be omitted entirely if a good approximation to $H$ is known, or computed infrequently or computed every time as the case may be. Note that it is assumed that the matrix $M$ is invertible - this may not always be the case and in some cases $M$ may be so badly conditioned that this process will not work, but it is expected that in many applications this process may result in convergence to the desired $c_k$.

Providers of plasma chambers may specify limiting cases, such as zero reference impedance, corresponding to specified voltages, and infinite reference impedance, corresponding to specified currents for energizing the plasma chamber. In these limiting cases, the appropriate generators are voltage sources for the zero reference impedance case, and current sources for the infinite reference impedance case. Conventional techniques that split the output from a single generator and use variable impedance elements to achieve the desired phase and amplitude relationships, however, have been expensive and relatively difficult to implement.

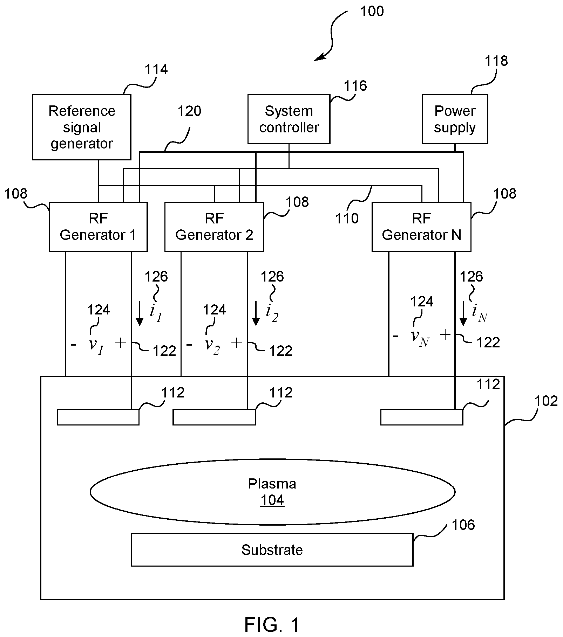

FIG. 1 illustrates an example matched source impedance driving system 100 that may be used to drive the antennas (e.g. electrodes) 112 of a plasma chamber 102 according to one embodiment of the present disclosure. The plasma chamber 102 includes an enclosure that is used to contain a plasma 104 for processing (e.g. deposition or etching) and a substrate 106. According to embodiments of the present disclosure, the matched source impedance driving system 100 includes multiple RF generators 108 that are each configured to measure a linear combination of a voltage 124 and a current 126 at a reference point 122, as well as a reference signal 110. The generators further adjust the magnitude and phase, with respect to the reference signal, of this linear combination of the voltage and the current to a target value received from a system controller 116 when delivering and when absorbing power.

The plasma chamber 102 may be any type that is capable of generating a plasma for processing a substrate 106. For example, although the plasma chamber 102 is shown having three antennas 112, it should be understood that the plasma chamber 102 may have any suitable quantity of antennas 112 or single or multiple inputs to a single or multiple antenna(s). Additionally, it is contemplated that the plasma chamber 102 may include multiple coils of wire (in lieu of the electrodes 112) within the plasma chamber 102, which coils function as antennas for emitting electro-magnetic energy into the plasma chamber 102. The reference signal 110 may be provided by a signal generator 114 or by one of the generators 108. The generators may also share a common DC supply 118 (over a power rail 120) from which power may be absorbed by generators 108 delivering power to the plasma system and returned to by generators 108 absorbing power from the plasma system.

In order to achieve uniform plasma excitation in a plasma chamber, multiple inputs to the exciting antenna may be utilized. These inputs are driven coherently with a certain specified amplitude and phase relationship between the inputs. The current state of the art has been to use a single RF generator coupled with a fixed or variable distribution network to drive multiple antenna (e.g.,electrode) inputs. In practice it is difficult to maintain the required amplitude and phase relationships and simultaneously provide a well-matched impedance to the single RF generator. The problem can be simplified if multiple phase locked generators are used to drive the separate electrode inputs. However a complication that frequently arises is that some of the generators may need to absorb power in order to maintain the required amplitude and phase relationships. Conventional generators, however, are not designed to absorb power in a controlled way; that is, to provide a specified amplitude and relative phase of some linear combination of voltage and current at the generator output or some other defined reference point while absorbing power.

In addition to the ability to absorb power in a controlled manner, it may also be useful to match the generator's source impedance to the requested linear combination of voltage and current so that the requested combination is less sensitive to changes in the plasma. For example, if the amplitude and phase relationship is specified as the forward (incident) component (i.e., $(v + Z_o i)/[2\sqrt{\text{Real}(Z_o)}]$ where $v$ is the voltage, $i$ the current and $Z_o$ a reference impedance), driving the input with a generator having a source impedance equal to this reference impedance dramatically simplifies the control problem because in that case the controlled variable, forward (incident) component, is insensitive to the impedance presented to the generator by the plasma system. Frequently, limiting cases, such as zero reference impedance, corresponding to specified voltages, and infinite reference impedance corresponding to specified currents, are specified. In the limiting cases, the appropriate generators are voltage sources and current sources, respectively.

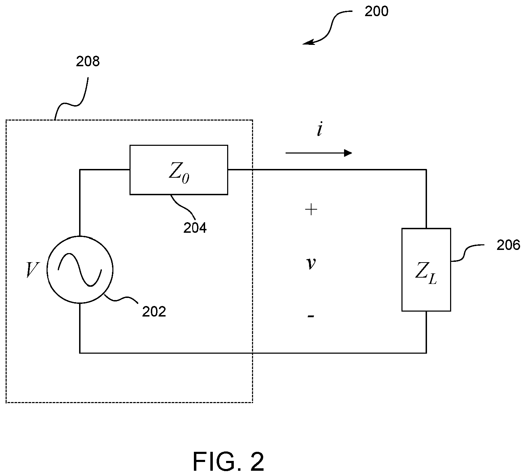

FIG. 2 is a diagram 200 illustrating the Thevenin equivalent circuit 208 of the RF generator 108 that is valid at some reference point (typically the output of the generator) coupled with a load 206. It is known that such a Thevenin equivalent circuit models the behavior of actual generators quite well (see US patent application 20150270104). The Thevenin equivalent circuit 208 includes a Thevenin equivalent voltage source ($V$) 202 coupled with a Thevenin equivalent impedance ($Z_o$) 204 as shown. Additionally, the Thevenin equivalent circuit 208 has an output to which the load impedance ($Z_L$) 206 is coupled. The source impedance of the generator 108 is the Thevenin equivalent impedance 204.

The forward (incident) component calculated with respect to the generator source impedance from the perspective of the generator at the interface to the load 206 scaled so that the magnitude squared of the forward component is the forward power incident on the load is:

$$a = \frac{v + Z_0 i}{2\sqrt{Real(Z_0)}}$$

Here, $v$ is the output voltage of the generator, and $i$ is the current out of the generator 208. Since

$$V = v + Z_0 i$$

it follows that the forward component $a$ is proportional to V and independent of the load impedance $Z_L$ 206. In this model of the generator, V tends to remain fixed for a fixed control input to the generator power amplifier or converter. Thus, controlling a scalar times the voltage plus the current multiplied by the generator source impedance makes the controlled quantity insensitive to the load impedance.

In a particular example, two antennas 112 are driven by two RF generators 108 at a single frequency (e.g., 13.56 MHz). This example does not exclude the existence of additional antennas 112, possibly also having corresponding inputs being driven at the same or another frequency (e.g. 2 MHz), coupled to the same plasma chamber 102. Additionally the present example is only concerned with the electromagnetic fields, voltages, and currents at the frequency of excitation and not with the harmonic content, mixing products and intermodulation products, although such may be important.

The choice of what to control at an antenna 112 input is somewhat arbitrary. If, for example, the amplitudes and relative phases of the voltages at each input are measured when the field distribution is as desired, replicating those voltages on an identical system will result in the same field distribution. Alternatively, the current at some inputs and voltages at other inputs can be controlled. In general, controlling a linear combination of voltages and currents at each antenna 112 controls the electrical field distribution. In this particular example, the inputs will be restricted to those for which current and voltage can be defined unambiguously.

Controlling a linear combination of voltage and current at each antenna 112 input controls all the input voltages and all the input currents. Thus, given one set of input conditions, either through measurement or through calculation (assuming the properties of the network are known), all the voltages and all the currents at all the inputs are known. Any one set of linear combinations of voltages ($v$) and currents ($i$) at the inputs of the antennas 112 can thus be converted to a different set of linear combinations of voltages and currents. For example, given a desired excitation of 10.0 ampere (10 + j0) at one input and (3 + j5) ampere at a second input, the currents can be applied to the inputs and the voltages at the inputs measured under this excitation. If, for example, under this excitation the voltages at the first and second inputs are measured as (55 - j20) volt and (-2 - j3) volt, respectively, then any of the following systems will result in a system wherein the generators (sources) are insensitive to the plasma load:

1) Using two current sources to drive the two inputs with a specification of: (10 + j0) A and (3 + j5) A: and
2) Using two voltage sources with a specification of (58.5 + j0) V and (-0.85 -j3.5) V;
3) Using two 50 ohm source impedance generators with a specification of 1542 W forward power with a forward component angle of 0°and 415 W forward power with a forward component angle of 61°.
4) Using a voltage source and a 3 - j2 ohm source impedance generator with a specification of (58.52 + j0) V and 27.1 W forward power calculated with respect to 3 - j2 ohm with a forward component angle of 39.4°.

Note, for this example, in all cases the first generator delivers 550 W into a 5.5 - j2 ohm load and the second generator absorbs 21 W from a -0.62 + j0.03 ohm load and that there are numerous more examples of this type.

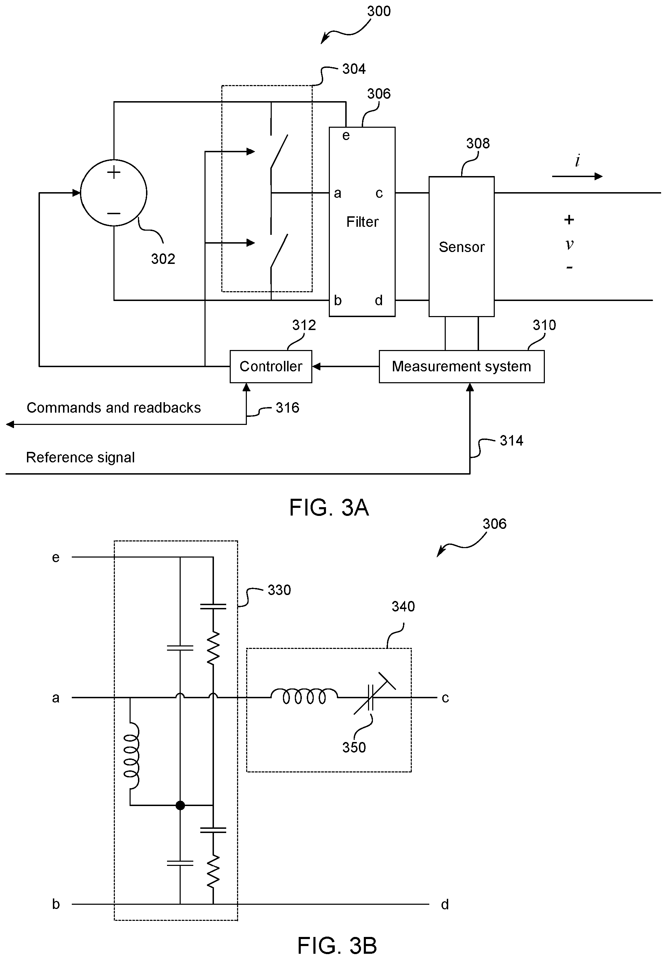

FIG. 3A illustrates an example RF generator 300, that may be used with the system 100 of FIG. 1 as a generator 108 according to one embodiment of the present disclosure. The RF generator 300 includes a DC source 302, a half bridge 304, a filter 306, a sensor 308, a measurement system 310, and a controller 312 coupled together as shown. The DC source 302, half bridge 304, sensor 308, measurement system 310, and controller 312 form a feedback loop for maintaining the output at a magnitude and phase relative to a reference signal 314 commanded through a communication channel 316 with a system controller (e.g. 116 of FIG. 1).

Conventional RF generators are not designed to absorb real power in a controlled way. That is, they are not typically designed to absorb a controlled amount of power with control over the phase of the voltage, current or linear combination of voltage and current at some reference point (e.g., at the output connector of the generator or some other point along the power delivery system). Embodiments of the RF generator 300 as shown, however, may be suitable for driving individual antenna 112 inputs of a plasma chamber 102 in cases where power may need to be absorbed in a controlled way.

The RF generator 300 may be provided with an engine (e.g., power amplifier, converter, inverter etc.) that can absorb power. Additionally, the RF generator 300 may be provided with an input from which to receive a phase reference signal 314. The RF generator 300 may also be provided with a measurement and control system that allows the generator to both deliver and absorb power in a controlled manner. Furthermore, the RF generator 300 can be calibrated for relatively accurate delivery and absorption of power while controlling the phase of a linear combination of voltage and current at some reference point with respect the input received at the phase reference input.

The RF generator 300 as shown is capable of controlling the magnitude and phase relative to a reference of a linear combination of voltage and current at some reference point when either delivering or absorbing power. When absorbing power, power can be returned to the DC source 302. This power can then either be dissipated or used to do useful work by, for example, supplying power to other RF generators 300 that deliver power to the plasma chamber 102 for example via a common power supply bus 120.

The RF generator 300 may be operated in any suitable mode that allows a specified output to be developed and maintained. In various embodiments, the RF generator 300 may have a finite source impedance, zero source impedance (i.e. a voltage source), or infinite source impedance (i.e. a current source). A finite source impedance can be achieved by operating the half bridge in a linear rather than switch-mode operation or by combining two half bridges in a balanced amplifier configuration to maintain efficiency while providing a finite source impedance. Operating the half bridge in switch mode and, for example, using a series resonant LC filter connected between the half bridge and the output or using a filter 306 with 180° delay or more generally with a delay equal to an even multiple of 90° creates a zero source impedance generator. Operating the half bridge in switch mode and using a filter 306 with a 90° delay or more generally with a delay equal to an odd multiple of 90° creates an infinite source impedance generator.

The even and odd multiples of 90° delays will often hold true for positive and negative multiples of 90°. A filter with a negative delay may have a positive phase lead. A relatively simple realization of a 90° delay filter may include a series inductor with reactance X followed by a shunt capacitor with reactance -X. Such a filter converts a voltage source with amplitude V to a current source with amplitude $V/Z_0$ where $Z_0$ is equal to the square root of L/C, where L is the inductance of the inductor and C the capacitance of the capacitor. This example generally describes a series resonant tank circuit operated at its resonant frequency with a voltage source, such as a half-bridge driving the tank circuit and taking the output between where the voltage source connects to the capacitor and the connection between the inductor and capacitor. The corresponding 90° delay phase lead (or -90° delay) filter has a series capacitor or reactance -X and a shunt inductor of reactance X. This filter may also convert a voltage source with amplitude V to a current source with amplitude $V/Z_0$ where $Z_0$ is equal to the square root of L/C where L is the inductance of the inductor and C the capacitance of the capacitor. This example may also describe a series resonant tank circuit operated at its resonant frequency with a voltage source such as a half-bridge driving the tank circuit, but in this case taking the output between where the voltage source connects to the inductor and the connection between the inductor and capacitor.

Filter delay in this context may be taken as the phase delay of the voltage transfer function when the output is terminated in a resistive load. A filter of arbitrary delay, for example 30°, is sensitive to the load resistance in which the filter is terminated achieving a 30° delay only at a specific terminating load resistance. A filter with a delay equal to an odd multiple of 90° maintains this delay for a wide range of terminating resistor values up to some high resistor value and a filter delay equal to an even multiple of 90° maintains this delay for a wide range of terminating resistor values down to some low resistor value. When considering filter delay, the delay is generally between some node in the generator, for example node a in FIG. 3A, and the reference point and may thus include the effects of circuitry such as the sensor 308 on the delay. Due to practical limitations true voltage and current sources are difficult to construct. If the achieved source impedance, $Z_0$, is low enough (e.g. $| Z_0| < 10$), the RF generator 300 may control its output voltage only. If the achieved source impedance, $Z_0$, is high enough (e.g. $| Z_0| > 250$), the RF generator 300 may control its output current only.

No RF generator can absorb power from a passive load, but in the case of multiple generators connected to the same plasma system some of the generators deliver power and some may absorb power. From the perspective of a generator 300 connected to an antenna 112 input from which it needs to absorb power, the generator 300 is connected to a power source. Adjustment of the amplitude and phase of the Thevenin equivalent voltage of the RF generator 300 allows controlled absorption of power from the source to which it is connected provided that the available power from the source to which the generator is connected is more than the power that the RF generator 300 needs to absorb. The actual limitations may be more restrictive and the ability to manipulate the power and phase of the chosen linear combination of voltage and current is also limited by the capabilities of the RF generator 300, such as the voltage, current and power limitations of the RF generator 300. The amplitude of the Thevenin equivalent voltage source of the generator 300 can be adjusted by adjusting the DC source 302 and the phase can be adjusted by adjusting the timing of the half bridge 304 switches.

The half bridge 304 is generally formed from two switches of any suitable type, such as two metal oxide semiconductor field effect transistors (MOSFETs), or high-electron-mobility transistors (HEMTs).

The sensor 308 may be a directional coupler or voltage and current (VI) sensor or any other suitable sensor. The measurement system 310 may be implemented using analog circuitry or an analog to digital converter and digital circuitry.

The controller 312 may include a processing system that executes instructions stored in a memory (e.g., computer readable media) to control the operation of the RF generator 300. In other embodiments, it is contemplated that the controller 312 may be embodied in other specific forms, such as using discrete and/or integrated analog circuitry, field programmable gate arrays (FPGAs), application specific integrated circuitry (ASICs), or any combination thereof.

The controller 312 may include one or more processors or other processing devices and memory. The one or more processors may process machine/computer-readable executable instructions and data, and the memory may store machine/computer-readable executable instructions. A processor is hardware and memory is hardware. The memory of the RF generator 300 may include random access memory (RAM) and/or other non-transitory memory, e.g., a non-transitory computer-readable medium such as one or more flash disks or hard drives. The non-transitory memory may include any tangible computer-readable medium including, for example, magnetic and/or optical disks, flash drives, and the like.

FIG. 3B illustrates an example filter 306 that may be used with the RF generator 300 of FIG. 3A according to one embodiment of the present disclosure. The filter 306 may include an inductive pre-loading circuit 330. The inductive pre-loading circuit provides inductive current for soft (zero voltage) switching without affecting the source impedance of the generator. A generator designed to absorb power may need more inductive current to maintain soft switching while absorbing power than a generator not specifically designed to absorb power. The filter may include a series resonant circuit 340. The series resonant circuit acts as a filter to remove harmonics created by the switching of the half bridge. When operated at the resonance frequency of the series resonant circuit 340, an amplifier 300 with this particular filter topology approximates a voltage source. The filter 306 may contain variable elements 350 to match the load to the generator. Certain variable elements affect the generator source impedance. The generator 300 may store information about how variable elements affect the generator source impedance and make that information available to e.g. the system controller 116.

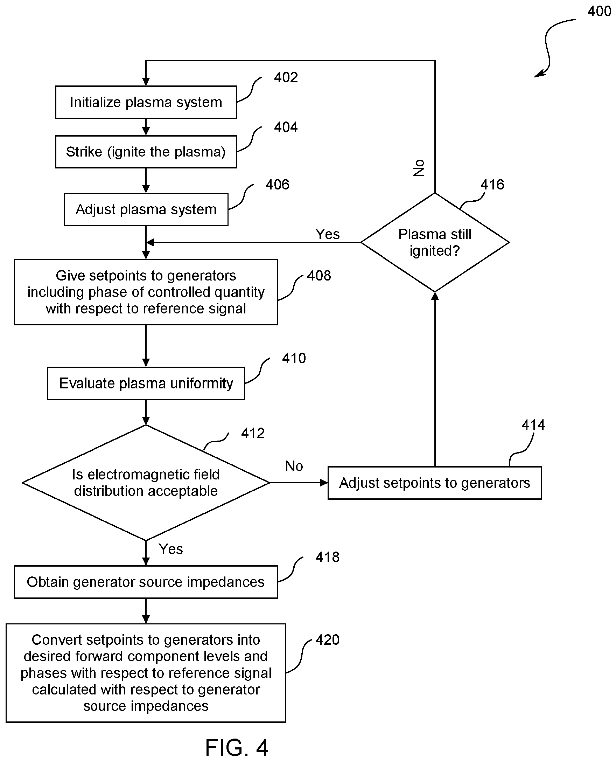

FIG. 4 illustrates an example process 400 that may be performed to prepare to drive a plasma system according to one embodiment of the present disclosure. This process may be carried out by the system controller 116 or another controller running the plasma system or a combination of the system controller 116 and other controllers running the plasma system, with or without other control inputs. At step 402, the plasma system is prepared for ignition and may include adjusting the gas mixture and pressure and setting any variable tuning elements present in the system to enhance plasma ignition. At step 404 the plasma is ignited, typically by turning on some or all of the generators. At step 406 the plasma system is adjusted to run after ignition and may involve adjusting the gas mixture and pressure, variable tuning elements present in the system (e.g. variable element 350), and power setpoints to the generators. At step 408 setpoints are given to the generators including phase of controlled quantity (e.g. current) with respect to reference signal. At step 410 the uniformity of the plasma is evaluated. This may be done through instrumentation in the plasma chamber or through evaluating substrates processed in the system. At step 412 a determination is made whether the electromagnetic field distribution is acceptable. If the electromagnetic field distribution is not acceptable, adjustments to the generator setpoints are made at step 414. If making the determination involved stopping the plasma system then steps 402 through 406 need to be repeated, otherwise the loop can continue at step 408 as shown in step 416. The loop continues until a determination is made at step 412 that the electromagnetic field distribution is acceptable. At step 418 the generator source impedances are obtained. This step may be omitted if none of the generators have variable components and the source impedances are fixed. At step 420 the generator setpoints are converted to desired forward component levels and phases with respect to a reference signal calculated with respect to the generator source impedances.

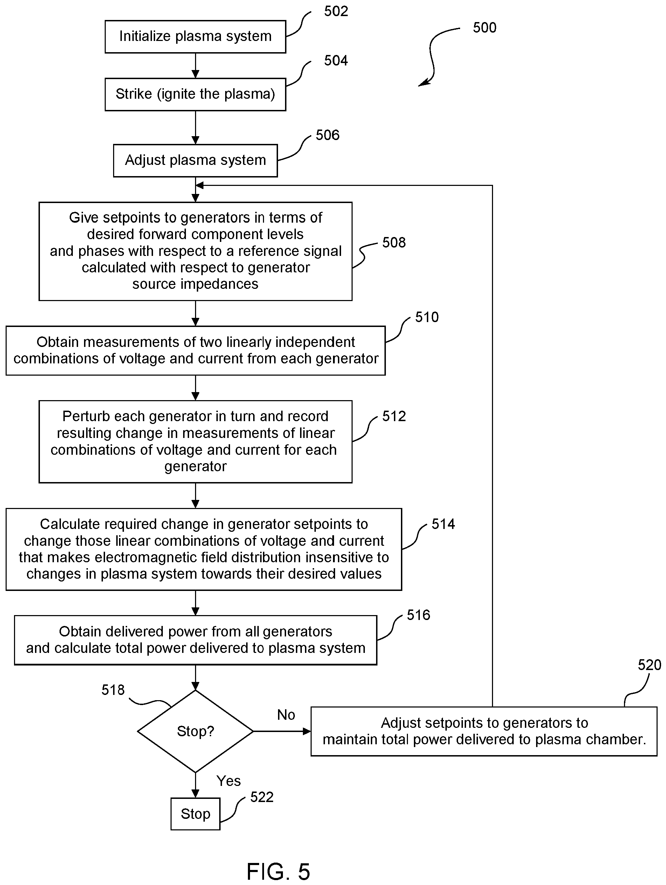

FIG. 5 illustrates an example process 500 that may be performed to drive a plasma system according to one embodiment of the present disclosure. Since this process involves closed loop control this process will typically not be carried out by human operators. Typically this process will be carried out by the system controller 116 or another available controller. At step 502 the plasma system is prepared for ignition and may include adjusting the gas mixture and pressure and setting any variable tuning elements present in the system to enhance plasma ignition. At step 504 the plasma is ignited, typically by turning on some or all of the generators. At step 506 the plasma system is adjusted to run after ignition and may involve adjusting the gas mixture and pressure, variable tuning elements present in the system, and power setpoints to the generators. At step 508 setpoints are given to the generators in terms of desired forward component levels and phases with respect to a reference signal calculated with respect to generator source impedances. At step 510 the controller obtains two linearly independent combinations of voltage and current from each generator, including the phase relationship of these combinations relative to a reference signal. At step 512 each generator is perturbed in turn and the resulting change in the measurements of the linear combinations of voltage and current recorded. Step 512 can be omitted if the linearized response of the system around the operating point is known with sufficient accuracy. Step 512 may, for example, be performed a few times at the beginning of a plasma processing step until the linearized response is known with sufficient accuracy and perhaps again if the process of adjusting the generator setpoints fail to move the linear combinations of voltage and current that makes the electromagnetic field distribution insensitive to changes in the plasma system towards their desired values. In step 514 the required change in generator setpoints to change those linear combinations of voltage and current that makes the electromagnetic field distribution insensitive to changes in the plasma system towards their desired values are calculated. At step 516 the controller obtains delivered power measurements from all the generators and calculates the total power delivered to the plasma system. At step 520 setpoints to all generators are adjusted to maintain total power delivered to the plasma. This adjustment can e.g. be done by adjusting all setpoints by a scalar multiplier. The loop continues until the process is complete as determined at steps 518. The process stops at step 522. The process only illustrates that part of the process that relates to the adjustment of the generator setpoints to maintain a desired electromagnetic field distribution in the plasma chamber. Other process that happen simultaneously may include adjustment of variable tuning elements, gas mixture, and gas pressure.

Although FIG. 4 and FIG. 5 describe examples of processes that may be performed to drive a plasma system according to an embodiment of the present disclosure, the features of the disclosed process may be embodied in other specific forms without deviating from the spirit and scope of the present disclosure. For example, the controller (e.g. 116) may perform additional, fewer, or different operations than those operations as described in the present example. As another example, the steps of the process described herein may be performed by a computing system not shown in FIG. 1, which may be, for example, a single computing system that controls the operation of all of the RF generators 300 implemented on the plasma chamber 102.

The description above includes example systems, methods, techniques, instruction sequences, and/or computer program products that embody techniques of the present disclosure. However, it is understood that the described disclosure may be practiced without these specific details.

In the present disclosure, the methods disclosed may be implemented as sets of instructions or software readable by a device. Further, it is understood that the specific order or hierarchy of steps in the methods disclosed are instances of example approaches. Based upon design preferences, it is understood that the specific order or hierarchy of steps in the method can be rearranged while remaining within the disclosed subject matter. The accompanying method claims present elements of the various steps in a sample order, and are not necessarily meant to be limited to the specific order or hierarchy presented.

The described disclosure may be provided as a computer program product, or software, that may include a machine-readable medium having stored thereon instructions, which may be used to program a computer system (or other electronic devices) to perform a process according to the present disclosure. A machine-readable medium includes any mechanism for storing information in a form (e.g., software, processing application) readable by a machine (e.g., a computer). The machine-readable medium may include, but is not limited to, magnetic storage medium (e.g., hard disk drive), optical storage medium (e.g., CD-ROM); magneto-optical storage medium, read only memory (ROM); random access memory (RAM); erasable programmable memory (e.g., EPROM and EEPROM); flash memory; or other types of medium suitable for storing electronic instructions.

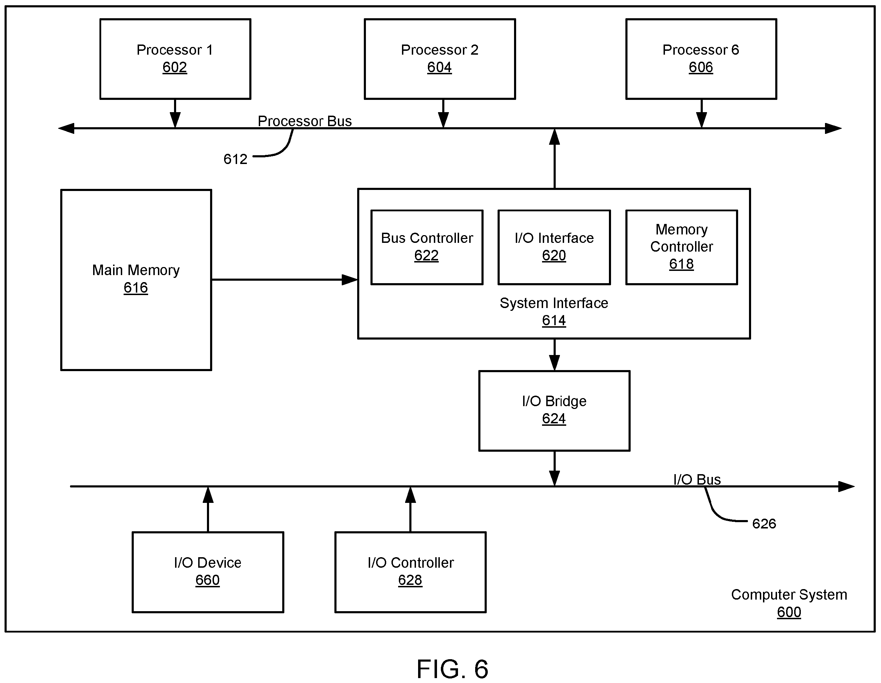

For example, FIG. 6 is a block diagram illustrating an example of a host or computer system 600 which may be used in implementing the embodiments of the present disclosure, such as the controller 312 as shown in FIG. 3A or system controller 116 shown in FIG. 1. The computer system (system) includes one or more processors 602-606. Processors 602-606 may include one or more internal levels of cache (not shown) and a bus controller or bus interface unit to direct interaction with the processor bus 612. Processor bus 612, also known as the host bus or the front side bus, may be used to couple the processors 602-606 with the system interface 614. System interface 614 may be connected to the processor bus 612 to interface other components of the system 600 with the processor bus 612. For example, system interface 614 may include a memory controller 613 for interfacing a main memory 616 with the processor bus 612. The main memory 616 typically includes one or more memory cards and a control circuit (not shown). System interface 614 may also include an input/output (I/O) interface 620 to interface one or more I/O bridges or I/O devices with the processor bus 612. One or more I/O controllers and/or I/O devices may be connected with the I/O bus 626, such as I/O controller 628 and I/O device 630, as illustrated.

I/O device 630 may also include an input device (not shown), such as an alphanumeric input device, including alphanumeric and other keys for communicating information and/or command selections to the processors 602-606. Another type of user input device includes cursor control, such as a mouse, a trackball, or cursor direction keys for communicating direction information and command selections to the processors 602-606 and for controlling cursor movement on the display device.

System 600 may include a dynamic storage device, referred to as main memory 616, or a random access memory (RAM) or other computer-readable devices coupled to the processor bus 612 for storing information and instructions to be executed by the processors 602-606. Main memory 616 also may be used for storing temporary variables or other intermediate information during execution of instructions by the processors 602-606. System 600 may include a read only memory (ROM) and/or other static storage device coupled to the processor bus 612 for storing static information and instructions for the processors 602-606. The system set forth in FIG. 6 is but one possible example of a computer system that may employ or be configured in accordance with aspects of the present disclosure.

The above techniques may be performed by computer system 600 in response to processor 604 executing one or more sequences of one or more instructions contained in main memory 616. These instructions may be read into main memory 616 from another machine-readable medium, such as a storage device. Execution of the sequences of instructions contained in main memory 616 may cause processors 602-606 to perform the process steps described herein. In alternative embodiments, circuitry may be used in place of or in combination with the software instructions. Thus, embodiments of the present disclosure may include both hardware and software components.

A computer readable medium includes any mechanism for storing or transmitting information in a form (e.g., software, processing application) readable by a machine (e.g., a computer). Such media may take the form of, but is not limited to, non-volatile media and volatile media. Non-volatile media includes optical or magnetic disks. Volatile media includes dynamic memory, such as main memory 616. Common forms of machine-readable medium may include, but is not limited to, magnetic storage medium (e.g., hard disk drive); optical storage medium (e.g., CD-ROM); magneto-optical storage medium; read only memory (ROM); random access memory (RAM); erasable programmable memory (e.g., EPROM and EEPROM); flash memory; or other types of medium suitable for storing electronic instructions.

Embodiments of the present disclosure include various operations or steps, which are described in this specification. The steps may be performed by hardware components or may be embodied in machine-executable instructions, which may be used to cause a general-purpose or special-purpose processor programmed with the instructions to perform the steps. Alternatively, the steps may be performed by a combination of hardware, software and/or firmware.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages.

While the present disclosure has been described with reference to various embodiments, it will be understood that these embodiments are illustrative and that the scope of the disclosure is not limited to them. Many variations, modifications, additions, and improvements are possible. More generally, embodiments in accordance with the present disclosure have been described in the context of particular implementations. Functionality may be separated or combined in blocks differently in various embodiments of the disclosure or described with different terminology. These and other variations, modifications, additions, and improvements may fall within the scope of the disclosure as defined in the claims that follow.

**Claims**

1. A radio frequency generator (108) with a source impedance $Z_g$ at a reference point (122) comprising:

    a reference input; and
    a controller (116) configured to control a magnitude and a phase, relative to a phase of a reference signal received at the reference input, of an output signal **characterised in that** the output signal is calculated according to $K(v + Z_g i)$, where $v$ is a voltage at the reference point, $i$ is a current out of the generator at the reference point, and $K$ is a scalar.

2. The radio frequency generator of claim 1, wherein $|Z_g| < 10$, and the controller is further to control a voltage of the output signal.

3. The radio frequency generator of claim 1, wherein $|Z_g| > 250$, and the controller is further to control a current of the output signal.

4. The radio frequency generator of claim 1, further comprising one of a plurality of radio frequency generators coupled to a corresponding plurality of antenna inputs configured in a plasma chamber.

5. The radio frequency generator of claim 1, further comprising a half bridge circuit comprising a first switch selectively coupling a first node of a direct current source to a node n1 of the radio frequency generator and a second switch selectively coupling the node n1 of the radio frequency generator to a second node of the direct current source.

6. The radio frequency generator of claim 5, further comprising an inductive pre-loading circuit coupled to the node n1 of the radio frequency generator, the inductive pre-loading circuit providing inductive current when the half bridge uses zero voltage switching.

7. The radio frequency generator of claim 6, further comprising a series resonant circuit connected to the node n1 of the radio frequency generator, the series resonant circuit to filter harmonics generated by switching of the half bridge circuit, the series resonant circuit having a resonant frequency essentially similar to the frequency at which the half bridge circuit is switched.

8. The radio frequency generator of claim 6, further comprising a filter with a delay equal to a positive or negative even multiple of 90 degrees, the filter coupled between the node n1 of the radio frequency generator and the reference point, wherein the controller is to control a voltage of the output signal.

9. The radio frequency generator of claim 6, further comprising a filter with a delay equal to a positive or negative odd multiple of 90 degrees coupled between the node n1 of the radio frequency generator and the reference point, wherein the controller is to control a current of the output signal.

10. The radio frequency generator of claim 1, wherein the controller is further to control a magnitude and a phase, relative to a phase of a reference signal received at the reference input, of an output signal calculated according to $K(v + Z_g i)$, when delivering power to and when absorbing power from a plasma chamber.

11. A method comprising:

receiving, by at least one processor that executes instructions stored in at least one memory and executed by at least one processor, a target value for a magnitude and a phase, relative to a phase of a reference signal received at a reference input, of an output signal calculated according to $K(v + Z_g i)$, for a radio frequency generator with a source impedance of $Z_g$ at a reference point, where $v$ is a voltage and $i$ is a current out of the radio frequency generator at the reference point and $K$ is a scalar;

receiving, using the instructions executed by the at least one processor, a measurement of a magnitude and a phase, relative to the phase of the reference signal received at the reference input, of the output signal calculated according to $K(v + Z_g i)$; and

controlling, using the instructions executed by the at least one processor, the radio frequency generator so that the measured $K(v + Z_g i)$ approaches the target value of $K(v + Z_g i)$.

12. The method of claim 11, further comprising controlling the output voltage of the output signal when $|Z_g| < 10$.

13. The method of claim 11, further comprising controlling the output current when $|Z_g| > 250$.

14. The method of claim 11, wherein the radio frequency generator comprises one of a plurality of radio frequency generators coupled to a corresponding plurality of antenna inputs configured in a plasma chamber.

15. The method of claim 11, further comprising providing inductive current when the radio frequency generator uses zero voltage switching using an inductive pre-loading circuit.

16. The method of claim 11, further comprising filtering harmonics generated by switching of the radio frequency generator, using a series resonant circuit having a resonant frequency essentially similar to the frequency at which the radio frequency generator is switched.

17. The method of claim 11, further comprising controlling the magnitude and the phase, relative to the phase of the reference signal received at the reference input, of the output signal calculated according to $K(v + Z_g i)$ when delivering power to and when absorbing power from a plasma chamber.

**Patentansprüche**

1. Funkfrequenzgenerator (108) mit einer Quellenimpedanz $Z_g$ an einem Referenzpunkt (122), umfassend:

einen Referenzeingang; und
eine Steuerung (116), welche konfiguriert ist, um eine Größe und eine Phase relativ zu einer Phase eines Referenzsignals zu steuern, welches an dem Referenzeingang empfangen wird, eines Ausgangssignals, **dadurch gekennzeichnet, dass** das Ausgangssignal nach $K(v + Z_g i)$ berechnet wird, wobei $v$ eine Spannung an dem Referenzpunkt ist, $i$ ein Strom aus dem Generator an dem Referenzpunkt ist und $K$ ein Skalar ist.

2. Funkfrequenzgenerator nach Anspruch 1, wobei $|Z_g| < 10$ ist und die Steuerung ferner zum Steuern einer Spannung des Ausgangssignals ist.

3. Funkfrequenzgenerator nach Anspruch 1, wobei $|Z_g| > 250$ ist und die Steuerung ferner zum Steuern eines Stroms des Ausgangssignals ist.

4. Funkfrequenzgenerator nach Anspruch 1, ferner umfassend einen einer Vielzahl von Funkfrequenzgeneratoren, welche mit einer entsprechenden Vielzahl von Antenneneingängen gekoppelt sind, welche in einer Plasmakammer konfiguriert sind.

5. Funkfrequenzgenerator nach Anspruch 1, ferner umfassend eine Halbbrückenschaltung, umfassend einen ersten Schalter, der selektiv einen ersten Knoten einer Gleichstromquelle mit einem Knoten n1 des Funkfrequenzgenerators koppelt, und einen zweiten Schalter umfasst, der selektiv den Knoten n1 des Funkfrequenzgenerators mit einem zweiten Knoten der Gleichstromquelle koppelt.

6. Funkfrequenzgenerator nach Anspruch 5, ferner umfassend eine induktive Vorladeschaltung, welche mit dem Knoten n1 des Funkfrequenzgenerators gekoppelt ist, wobei die induktive Vorladeschaltung einen induktiven Strom bereitstellt, wenn die Halbbrücke eine Null spannungsschaltung verwendet.

7. Funkfrequenzgenerator nach Anspruch 6, ferner umfassend eine Reihenresonanzschaltung, welche mit dem Knoten n1 des Funkfrequenzgenerators verbunden ist, wobei die Reihenresonanzschaltung Oberschwingungen filtert, die durch das Umschalten der Halbbrückenschaltung erzeugt werden, wobei die Reihenresonanzschaltung eine Resonanzfrequenz aufweist, die im Wesentlichen der Frequenz ähnlich ist, mit der die Halbbrückenschaltung umgeschaltet wird.

8. Funkfrequenzgenerator nach Anspruch 6, ferner umfassend einen Filter mit einer Verzögerung die einem positiven oder negativen geraden Mehrfachen von 90 Grad gleich ist, wobei der Filter zwischen dem Knoten n1 des Funkfrequenzgenerators und dem Referenzpunkt gekoppelt ist, wobei die Steuerung zum Steuern einer Spannung des Ausgangssignals ist.

9. Funkfrequenzgenerator nach Anspruch 6, ferner umfassend einen Filter mit einer Verzögerung, die einem positiven oder negativen ungeraden Mehrfachen von 90 Grad gleich ist, welcher zwischen dem Knoten n1 des Funkfrequenzgenerators und dem Referenzpunkt gekoppelt ist, wobei die Steuerung zum Steuerung eines Stroms des Ausgangssignals ist.

10. Funkfrequenzgenerator nach Anspruch 1, wobei die Steuerung ferner zum Steuern einer Größe und einer Phase relativ zu einer Phase eines Referenzsignals ist, welches an dem Referenzeingang empfangen wird, eines Ausgangssignals, welches nach $K(v + Z_g i)$ berechnet wird, bei dem Zuführen einer Leistung zu und beim Absorbieren einer Leistung von einer Plasmakamera.

11. Verfahren, umfassend:

Empfangen, durch mindestens einen Prozessor, welcher Anweisungen ausführt, die in mindestens einem Speicher gespeichert sind und durch mindestens einen Prozessor ausgeführt werden, eines Zielwerts für eine Größe und eine Phase relativ zu einer Phase eines Referenzsignals, welches an einem Referenzeingang empfangen wird, eines Ausgangssignals, berechnet nach $K(v + Z_g i)$ für einen Funkfrequenzgenerator mit einer Quellenimpedanz von $Z_g$ an einem Referenzpunkt, wobei $v$ eine Spannung ist und $i$ ein Strom aus dem Funkfrequenzgenerator an dem Referenzpunkt ist und $K$ ein Skalar ist,

Empfangen, unter Verwendung der Anweisungen, die durch den mindestens einen Prozessor ausgeführt werden, einer Messung einer Größe und einer Phase relativ zu der Phase des Referenzsignals, welches an dem Referenzeingang empfangen wird, des Ausgangssignals, berechnet nach $K(v + Z_g i)$; und

Steuern, unter Verwendung der Anweisungen, die durch den mindestens einen Prozessor ausgeführt werden, des Funkfrequenzgenerators derart, dass der gemessene $K(v + Z_g i)$ sich dem Zielwert von $K(v + Z_g i)$ nähert.

12. Verfahren nach Anspruch 11, ferner umfassend das Steuern der Ausgangsspannung des Ausgangssignals, wenn $|Z_g| < 10$ ist.

13. Verfahren nach Anspruch 11, ferner umfassend das Steuern des Ausgangsstroms, wenn $|Z_g| > 250$ ist.

14. Verfahren nach Anspruch 11, wobei der Funkfrequenzgenerator einen von einer Vielzahl von Funkfrequenzgeneratoren umfasst, welche mit einer entsprechenden Vielzahl von Antenneneingängen gekoppelt sind, welche in einer Plasmakammer konfiguriert sind.

**15.** Verfahren nach Anspruch 11, ferner umfassend das Bereitstellen eines induktiven Stroms, wenn der Funkfrequenzgenerator eine Nullspannschaltung verwendet, unter Verwendung einer induktiven Vorladeschaltung.

**16.** Verfahren nach Anspruch 11, ferner umfassend das Filtern von Oberschwingungen, die durch das Umschalten des Funkfrequenzgenerators erzeugt werden, unter Verwendung einer Reihenresonanzschaltung, welche eine Resonanzfrequenz aufweist, die im Wesentlichen zu der Frequenz ähnlich ist, mit welcher der Funkfrequenzgenerator umgeschaltet wird.

**17.** Verfahren nach Anspruch 11,
ferner umfassend das Steuern der Größe und der Phase relativ zu der Phase des Referenzsignals, welches an dem Referenzeingang empfangen wird, des Ausgangssignals, welches nach $K(v + Z_g i)$ berechnet wird, bei dem Zuführen einer Leistung zu und beim Absorbieren einer Leistung von einer Plasmakamera.

**Revendications**

**1.** Générateur de fréquence radio (108) avec une impédance de source $Z_g$ au niveau d'un point de référence (122) comprenant:

une entrée de référence; et
une commande (116) configurée pour commander une amplitude et une phase, par rapport à une phase d'un signal de référence reçu au niveau de l'entrée de référence, d'un signal de sortie, **caractérisé en ce que** le signal de sortie est calculé selon $K(v + Z_g i)$, où $v$ est une tension au niveau du point de référence, $i$ est un courant à la sortie du générateur au niveau du point de référence, et $K$ est un scalaire.

**2.** Générateur de fréquence radio selon la revendication 1, dans lequel $|Z_g| < 10$, et la commande est chargée en outre de commander une tension du signal de sortie.

**3.** Générateur de fréquence radio selon la revendication 1, dans lequel $|Z_g| > 250$, et la commande est chargée en outre de commander un courant du signal de sortie.

**4.** Générateur de fréquence radio selon la revendication 1, comprenant en outre l'un d'une pluralité de générateurs de fréquence radio couplés à une pluralité correspondante d'entrées d'antenne configurées dans une chambre à plasma.

**5.** Générateur de fréquence radio selon la revendication 1, comprenant en outre un circuit demi-pont comprenant un premier commutateur couplant sélectivement un premier nœud d'une source de courant continu à un nœud n1 du générateur de fréquence radio et un second commutateur couplant sélectivement le nœud n1 du générateur de fréquence radio à un second nœud de la source à courant continu.

**6.** Générateur de fréquence radio selon la revendication 5, comprenant en outre un circuit de pré-charge inductif couplé au nœud n1 du générateur de fréquence radio, le circuit de pré-charge inductif fournissant un courant inductif lorsque le demi-pont utilise une commutation au zéro de la tension.

**7.** Générateur de fréquence radio selon la revendication 6, comprenant en outre un circuit résonant en série connecté au nœud n1 du générateur de fréquence radio, le circuit résonant en série filtrant des harmoniques générées par la commutation du circuit demi-pont, le circuit résonant en série ayant une fréquence de résonance sensiblement similaire à la fréquence à laquelle le circuit demi-pont est commuté.

**8.** Générateur de fréquence radio selon la revendication 6, comprenant en outre un filtre avec un délai égal à un multiple pair de 90 degrés positif ou négatif, le filtre étant couplé entre le nœud n1 du générateur de fréquence radio et le point de référence, dans lequel la commande est chargée de commander une tension du signal de sortie.

**9.** Générateur de fréquence radio selon la revendication 6, comprenant en outre un filtre avec un délai égal à un multiple impair de 90 degrés positif ou négatif couplé entre le nœud n1 du générateur de fréquence radio et le point de référence, dans lequel la commande est chargée de commander un courant du signal de sortie.

**10.** Générateur de fréquence radio selon la revendication 1, dans lequel la commande est chargée en outre de commander une amplitude et une phase, par rapport à une phase d'un signal de référence reçu au niveau de l'entrée de référence, d'un signal de sortie calculé selon $K(v + Z_g i)$, lors de la fourniture de puissance à et lors de l'absorption de puissance d'une chambre à plasma.

11. Procédé comprenant:

la réception, par au moins un processeur qui exécute des instructions stockées dans au moins une mémoire et exécutées par au moins un processeur, d'une valeur cible pour une amplitude et une phase, par rapport à une phase d'un signal de référence reçu au niveau d'une entrée de référence, d'un signal de sortie calculé selon $K(v + Z_g i)$, pour un générateur de fréquence radio avec une impédance de source de $Z_g$ au niveau d'un point de référence, où $v$ est une tension et $i$ est un courant à la sortie du générateur de fréquence radio au niveau du point de référence et $K$ est un scalaire;
la réception, en utilisant les instructions exécutées par l'au moins un processeur, d'une mesure d'une amplitude et d'une phase, par rapport à la phase du signal de référence reçu au niveau de l'entrée de référence, du signal de sortie calculé selon $K(v + Z_g i)$; et
la commande, en utilisant les instructions exécutées par l'au moins un processeur, du générateur de fréquence radio de manière que le $K(v + Z_g i)$ mesuré approche la valeur cible de $K(v + Z_g i)$.

12. Procédé selon la revendication 11, comprenant en outre la commande de la tension de sortie du signal de sortie lorsque $|Z_g| < 10$.

13. Procédé selon la revendication 11, comprenant en outre la commande du courant de sortie lorsque $|Z_g| > 250$.

14. Procédé selon la revendication 11, dans lequel le générateur de fréquence radio comprend l'un parmi une pluralité de générateurs de fréquence radio couplés à une pluralité correspondante d'entrées d'antenne configurées dans une chambre à plasma.

15. Procédé selon la revendication 11, comprenant en outre la fourniture d'un courant inductif lorsque le générateur de fréquence radio utilise une commutation au zéro de la tension en utilisant un circuit de pré-charge inductif.

16. Procédé selon la revendication 11, comprenant en outre le filtrage d'harmoniques générées par la commutation du générateur de fréquence radio, en utilisant un circuit résonant en série ayant une fréquence de résonance sensiblement similaire à la fréquence à laquelle le générateur de fréquence radio est commuté.

17. Procédé selon la revendication 11,
comprenant en outre la commande de l'amplitude et de la phase, par rapport à la phase du signal de référence reçu au niveau de l'entrée de référence, du signal de sortie calculé selon $K(v + Z_g i)$ lors de la fourniture de puissance à et lors de l'absorption de puissance d'une chambre à plasma.

FIG. 1

FIG. 2

300

304

306

302

308

$i$

+

$v$

-

e

a    c

Filter

b    d

Sensor

312

310

Controller ◄— Measurement system

Commands and readbacks    316

Reference signal    314

## FIG. 3A

306

e

330

340

a

c

350

b

d

## FIG. 3B

400

Initialize plasma system — 402

Strike (ignite the plasma) — 404

Adjust plasma system — 406

Give setpoints to generators
including phase of controlled quantity
with respect to reference signal — 408

Evaluate plasma uniformity — 410

Is electromagnetic field
distribution acceptable — 412

Plasma still
ignited? — 416

No

Yes

No → Adjust setpoints to generators — 414

Yes

Obtain generator source impedances — 418

Convert setpoints to generators into
desired forward component levels and
phases with respect to reference signal
calculated with respect to generator
source impedances — 420

FIG. 4

502 Initialize plasma system

504 Strike (ignite the plasma)

506 Adjust plasma system

508 Give setpoints to generators in terms of desired forward component levels and phases with respect to a reference signal calculated with respect to generator source impedances

510 Obtain measurements of two linearly independent combinations of voltage and current from each generator

512 Perturb each generator in turn and record resulting change in measurements of linear combinations of voltage and current for each generator

514 Calculate required change in generator setpoints to change those linear combinations of voltage and current that makes electromagnetic field distribution insensitive to changes in plasma system towards their desired values

516 Obtain delivered power from all generators and calculate total power delivered to plasma system

518 Stop?

No

520 Adjust setpoints to generators to maintain total power delivered to plasma chamber.

Yes

522 Stop

FIG. 5

**FIG. 6**

Processor 1
602

Processor 2
604

Processor 6
606

Processor Bus

612

Main Memory
616

System Interface
614

Bus Controller
622

I/O Interface
620

Memory Controller
618

I/O Bridge
624

I/O Bus

626

I/O Device
660

I/O Controller
628

Computer System
600

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017011264 A1
- WO 2010129398 A2
- US 2009281741 A1
- US 2015270104 A1
- US 2010175832 A1
- US 20150270104 A